# EUROPÄISCHE PATENTSCHRIFT

(11) **EP 1 516 375 B1**
(45) Veröffentlichungstag und Bekanntmachung des Hinweises auf die Patenterteilung: **13.01.2016**
(21) Anmeldenummer: 03740073.6
(22) Anmeldetag: 10.06.2003
(51) Int. Cl.: H01L 51/30, H01L 51/00

(54) **HERSTELLUNGSVERFAHREN FÜR EIN MATERIAL FÜR EINE DÜNNE UND NIEDRIG LEITFÄHIGE FUNKTIONSSCHICHT FÜR EINE OLED.**
PRODUCTION METHOD FOR A MATERIAL FOR A THIN AND LOW-CONDUCTIVE FUNCTIONAL LAYER FOR AN OLED
PROCEDE DE FABRICATION D'UN MATERIAU DESTINE A UNE COUCHE FONCTIONNELLE MINCE ET FAIBLEMENT CONDUCTRICE POUR UNE OLED

(30) Priorität: 14.06.2002 DE 10226616
(43) Veröffentlichungstag der Anmeldung: 23.03.2005
(73) Patentinhaber: OSRAM OLED GmbH, 93049 Regensburg (DE)
(72) Erfinder: WITTMANN, Georg, 91074 Herzogenaurach (DE); HEUSER, Karsten, 91056 Erlangen (DE); BIRNSTOCK, Jan, 01187 Dresden (DE); KANITZ, Andreas, 91333 Höchstadt (DE); WÖRLE, Jasmin, 90763 Fürth (DE)
(74) Vertreter: Epping - Hermann - Fischer
(86) Internationale Anmeldenummer: PCT/DE2003/001912
(87) Internationale Veröffentlichungsnummer: WO 2003/107454

(56) Entgegenhaltungen:
- EP-A- 1 081 548
- WO-A-01/81012
- WO-A-02/067273
- KIM J Y ET AL: 'Enhancement of electrical conductivity of poly(3,4-ethylenedioxythiop hene)/poly(4-styrene sulfonate) by a change of solvents' SYNTH. MET. (SWITZERLAND), SYNTHETIC METALS, ELSEVIER, SWITZERLAND Bd. 126, Nr. 2-3, 14 Februar 2002, Seiten 311 - 316, XP001189321 ISSN: 0379-6779
- PATENT ABSTRACTS OF JAPAN Bd. 2000, Nr. 06, 22. September 2000 (2000-09-22) & JP 2000 090732 A (MATSUSHITA ELECTRIC IND CO LTD), 31. März 2000 (2000-03-31)

## Beschreibung

Die Erfindung betrifft ein Verfahren zur Herstellung eines Materials für eine dünne und niedrig leitfähige Funktionsschicht einer organischen lichtemittierenden Diode (OLED), insbesondere für einen niedrig leitfähigen Polymerfilm, der für eine Anwendung als Injektions- und/oder Barriereschicht einer OLED geeignet ist.

Es sind Materialien für Injektionsschichten für OLEDs bekannt, beispielsweise aus PEDOT-PSS [Poly(3,4-ethylene-dioxythiophene)-poly(styrene-sulfonate)] oder PANI(Polyanilin)-PSS. Diese Materialien ergeben Injektionsschichten als dünne Filme des jeweiligen Funktionspolymers. Bei der.Herstellung der Injektionsschicht ist man jedoch auf sehr präzis eingestellte Leitfähigkeiten angewiesen. Beispielsweise hat ein organisches Passiv-Matrix-Display (PMD) auf Basis π-konjugierter Polymere eine Schicht des leitfähigen Polymergemischs PEDOT:PSS (Poly(3,4-ethylendioxythiophen): Poly(4-styrolsulfonsäure)), die eine Dicke von typischerweise ca. 100nm aufweist und bevorzugt strukturiert ist. Diese Schicht darf keine zu hohe Leitfähigkeit aufweisen, da es sonst zu einem "Übersprechen" zwischen den einzelnen Bildpunkten des Displays kommt. Wenn die Leitfähigkeit jedoch zu niedrig ist, wird die Effizienz des Displays kleiner, da die Injektion und der Stromtransport stark beeinträchtigt und damit das ganze Bauteil unwirtschaftlich wird.

Es sind zwar Verfahren bekannt, die Leitfähigkeit des Polymergemisches in einem bestimmten Maße zu variieren, allerdings werden dabei auch die Eigenschaften, insbesondere die rheologischen, der Polymerdispersion oder -lösung, z.B. die Oberflächenspannung und/oder die Viskosität verändert.

Dies ist jedoch nachteilig an den bekannten Verfahren, da eines der grundsätzlichen Probleme beim Umgang mit leitenden Polymeren' die Frage ist, wie sie auf die zu beschichtenden Substrate aufgebracht werden. Verschiedene Beschichtungsverfahren, mit deren Hilfe das Polymer naßchemisch aus einer Lösung oder Dispersion aufgebracht wird, sind üblich, z.B. Spin-Coating, Druckverfahren wie Siebdruck, Tintenstrahldruck oder Flexodruck sowie Rakelverfahren. Alle Verfahren haben gemeinsam, dass für die Prozessierung einer homogenen Schicht und/oder einer definierten Dicke die Oberflächenspannung, die Viskosität und die Konzentration der Lösung oder Dispersion eine kritische Rolle spielen.

Aufgabe der vorliegenden Erfindung ist es daher, ein Verfahren zur Herstellung eines Materials für einen niedrig leitfähigen Polymerfilm zur Verfügung zu stellen, bei dem die Leitfähigkeit des herzustellenden Polymerfilms, unter Beibehaltung der für das Beschichtungsverfahren optimalen Lösungs- und/oder Dispersionseigenschaften, gezielt eingestellt werden kann.

Es ist die allgemeine Erkenntnis der Erfindung, dass eine Mischung von verschiedenen Fraktionen eines einzigen Funktionspolymers eine durch das Mischungsverhältnis einstellbare Leitfähigkeit hat, wobei die rheologischen Eigenschaften einer derartigen Mischung durch das Mischungsverhältnis der Fraktionen unbeeinträchtigt sind.

Es wird ein Material zur Bildung eines dünnen Films angegeben, der eine einstellbare Leitfähigkeit im Bereich von 10⁻⁴ S/cm bis 10⁻⁶ S/cm und eine Dicke zwischen 10 und 300 nm hat, wobei das Material eine Mischung aus zumindest zwei verschiedenen Fraktionen eines Funktionspolymers umfasst, nämlich eine erste Fraktion, die auf einer Dispersion des Funktionspolymers in einem ersten Lösungsmittel basiert, in dem das Funktionspolymer zumindest teilweise dispergiert ist und eine zweite Fraktion an Funktionspolymer, die auf einer echten Lösung des Funktionspolymers in einem zweiten Lösungsmittel basiert, wobei die beiden Fraktionen gemeinsam verarbeitet, dispergiert und/oder aufgelöst sind und durch das Mischungsverhältnis der zumindest zwei Fraktionen die Leitfähigkeit des aus diesem Material gebildeten dünnen Films einstellbar ist. Gegenstand der Erfindung ist ein Verfahren zur Herstellung eines Materials zur Bildung eines dünnen Films, bei dem eine Mischung aus zwei verschiedenen Fraktionen eines Funktionspolymers, gegebenenfalls in einem Lösungsmittel, kombiniert wird.

Nach einer Ausführungsform des Verfahrens wird dazu eine Dispersion des Funktionspolymers und eine Lösung des Funktionspolymers mit hochsiedendem Lösungsmittel versetzt, dann destillativ die niedriger siedenden Lösungsmittel so entfernt, dass letztendlich die verschiedenen Fraktionen an Funktionspolymer im hochsiedenden Lösungsmittel im wesentlichen das Material bilden. Dabei sieht eine Ausführungsform des Verfahrens vor, dass jeweils das hochsiedende Lösungsmittel in gleichen Teilen, wie die Fraktion vorliegt, zugesetzt wird.

Nach einer vorteilhaften Ausführungsform ist das Material im wesentlichen frei von dem Lösungsmittel und/oder Dispersionsmittel der zugrunde liegenden Fraktionen und/oder umfasst ein zusätzliches, drittes Lösungsmittel. Das Material kann beliebige weitere Zusätze und Additive, wie sie für diese Arten der Materialien üblich und/oder sinnvoll sind, wie Entschäumer, oder Netzmittel etc enthalten.

Als "Material" wird vorliegend immer das Material zur Bildung einer Funktionsschicht einer OLED bezeichnet.

Nach einer anderen Ausführungsform liegen die beiden Fraktionen vor der Dispersion/Lösung jeweils in Trockensubstanz vor.

Die beiden Fraktionen bezeichnen zwei Modifikationen, also zwei vermutlich verschiedene Zustände eines Stoffes.

Nach einer vorteilhaften Ausführungsform ist das Funktionspolymer PEDOT oder PANI.

Nach einer vorteilhaften Ausführungsform liegt das Funktionspolymer als Copolymer oder Mischung vor, das PSS Polystyrolsulfonat als Anionen umfasst.

Nach einer Ausführungsform ist das erste Lösungsmittel Wasser oder eine andere Komponente mit hoher Polarität, in der das Funktionspolymer im wesentlichen unlöslich ist.

Nach einer Ausführungsform der Erfindung ist das zweite Lösungsmittel Ethanol oder ein anderes niedrig siedendes, polares Lösungsmittel, bevorzugt ein polar-protisches, das H-Brückenbindungen ausbilden kann.

Unter dem Begriff "niedrig siedend" werden hier Lösungsmittel verstanden, die bis zu 150°C Siedetemperatur haben.

Nach einer Ausführungsform ist das dritte Lösungsmittel verschieden von dem ersten und/oder dem zweiten Lösungsmittel.

Nach einer vorteilhaften Ausführungsform wird als drittes Lösungmittel Ethylenglykol oder ein sonstiger Alkohol eingesetzt, insbesondere auch Mischungen mehrerer Alkohole, und/ oder Alkohole mit einem Kohlenstoffgehalt von C4 bis C10, verzweigt und unverzweigt, auch mehrwertige Alkohole, bzw. Gemische daraus, sowie Gemische mit Wasser, besonders bevorzugt Glycol und Glycerol.

Als Injektionsschicht wird hier ein dünner Film aus Funktionspolymer, der zwischen der Anode und der Emitterschicht einer OLED und in der Regel strukturiert angeordnet ist, bezeichnet. Diese Schicht erhöht Effizienz und Lebensdauer der Elektroden, insbesondere einer ITO-Anode.

Der Begriff "Lösung" wird verwendet, wenn einzelne Polymerteilchen im wesentlichen von Lösungsmittelmolekülen umgeben sind und er steht im Gegensatz zum Begriff "Dispersion" der den Zustand bezeichnet, in dem einzelne Polymerteilchen konglomerieren und beispielsweise Cluster bilden, sich aber nicht niederschlagen oder absetzen, sondern im wesentlichen in der dispergiert sind und keinen Niederschlag, also größere Feststoffagglomerationen, bilden. Ob eine Komponente hier als Lösungsmittel oder als Dispersionsmittel bezeichnet wird hängt nur davon ab, wie das jeweils in Rede stehende Funktionspolymer sich in diesem Mittel verhält. Zu betrachten sind jeweils die Bedingungen, die während der Herstellung, Lagerung und/oder Verarbeitung herrschen.

Der Begriff "organisches Material" oder "Funktionsmaterial" oder "Funktionspolymer" umfasst hier alle Arten von organischen, metallorganischen und/oder organisch-anorganischen Kunststoffen (Hybride), insbesondere die, die im Englischen z.B. mit "plastics" bezeichnet werden. Es handelt sich um alle Arten von Stoffen mit Ausnahme der Halbleiter, die die klassischen Dioden bilden (Germanium, Silizium), und der typischen metallischen Leiter. Eine Beschränkung im dogmatischen Sinn auf organisches Material als Kohlenstoff-enthaltendes Material ist demnach nicht vorgesehen, vielmehr ist auch an den breiten Einsatz von z.B. Siliconen gedacht. Weiterhin soll der Term keiner Beschränkung im Hinblick auf die Molekülgröße, insbesondere auf polymere und/oder oligomere Materialien unterliegen, sondern es ist durchaus auch der Einsatz von "small molecules" möglich. Der Wortbestandteil "polymer" im Funktionspolymer ist historisch bedingt und enthält insofern keine Aussage über das Vorliegen einer tatsächlich polymeren Verbindung und keine Aussage darüber, ob es sich um ein Polymergemisch oder ein Copolymer handelt oder nicht.

Als Trockensubstanz wird hier ein Stoff bezeichnet, der im wesentlichen frei von Lösungsmittel ist.

Im Folgenden wird die Erfindung noch anhand eines Herstellungsbeispiels erläutert:

Hier wird erstmals ohne Änderung der Lösungsmittelumgebung die Leitfähigkeit um viele Größenordnungen modifiziert. Dabei kommt beispielsweise eine Mischung aus zwei unterschiedlichen PEDOT Lösungen (beide mit dem gleichen Lösungsmittel, z.B. Ethylenglykol) zum Einsatz, die Aufgrund ihrer Vorgeschichte (die eine Lösung wird aus wasserbasierter Lösung, die andere aus ethanolbasierter Lösung hergestellt) unterschiedliche Leitfähigkeiten besitzen. Die Lösung, die aus wasserbasiertem PEDOT (WPEDOT) gewonnen wurde hat einen spezifischen Widerstand von 10^2 Ωcm, die aus ethanolbasiertem PEDOT (EPEDOT) gewonnene einen von 10^7 Ωcm.

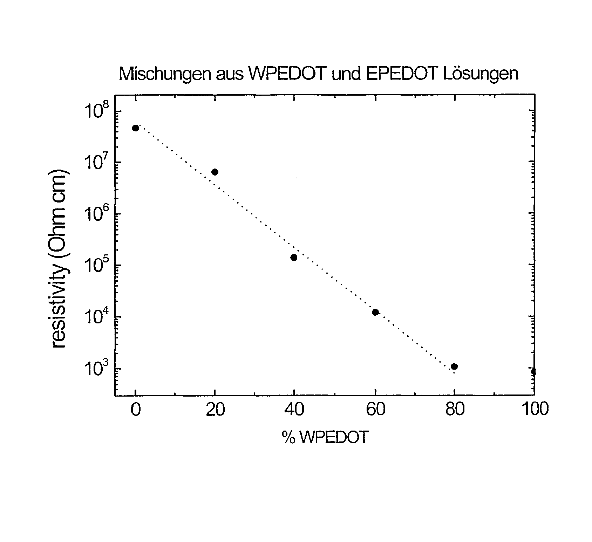

Zur Herstellung der Ausgangsmaterialien WPEDOT und EPEDOT wird den ursprünglichen Lösungen die unter anderem z.B. kommerziell von HC Starck vertrieben werden, das gleiche Volumen Ethylenglykol zugegeben und anschließend das ursprüngliche Lösungsmittel in einem Rotationsverdampfer abdestilliert. Da Ethylenglykol erst bei 200°C destillierbar ist, bleibt anschließend eine reine glykolische PEDOT Lösung. Da die Ursprungsmaterialien WPEDOT und EPEDOT anderer Natur sind wird im Falle des WPEDOT die Leitfähigkeit durch das Ersetzen des Wasser durch Ethylenglykol drastisch reduziert, was an dem dispersiven Charakter des WPEDOT liegt. Im Falle des EPEDOT, wobei es sich um eine wirkliche Lösung handelt, wird die Leitfähigkeit durch das Ersetzen des Ethanols durch Ethylenglykol nicht verändert. Damit entstehen zwei glykolische PEDOT Variationen mit 5 Größenordungen unterschiedlicher Leitfähigkeit. Durch das Mischen (Blenden) der beiden Lösungen kann nun jede Leitfähigkeit dazwischen eingestellt werden (siehe Figur 1).

Durch die vorliegende Erfindung soll das eingangs beschriebene Problem der gezielten Feineinstellung ("Tuning") der Leitfähigkeit des Polymerfilms über viele Größenordnungen unter Beibehaltung der für das Beschichtungsverfahren optimalen Lösungs- bzw. Dispersionseigenschaften, gelöst werden. Durch diese Erfindung wird es möglich, einen Polymerfilm, dessen Leitfähigkeit in einem weiten Bereich beliebig gewählt werden kann, mit einem preiswerten Beschichtungsverfahren, wie z.B. Siebdruck, strukturiert oder großflächig mit hoher Auflösung auf ein Substrat aufzubringen. Möglich ist dies, da die Leitfähigkeit des Polymers durch verschiedene Mischungsverhältnisse der ersten und zweiten Fraktion des Funktionspolymers und/oder durch die Wahl des dritten Lösungsmittel variiert wird, ohne Additive hinzuzugeben. Damit bleiben Oberflächenspannung und Viskosität unverändert und die Verdruckbarkeit des Polymers erhalten.

Die Erfindung betrifft ein Verfahren zur Herstellung eines Materials für eine Funktionsschicht einer organischen lichtemittierenden Diode (OLED), insbesondere für einen niedrig leitfähigen Polymerfilm, der für eine Anwendung als Injektions-Planarisierungs- und/oder Barriereschicht einer organischen lichtemittierenden Diode (OLED) geeignet ist.

## Patentansprüche

1. Verfahren zur Herstellung eines Materials für eine Funktionsschicht mit einer Leitfähigkeit im Bereich von 10⁻⁴ S/cm bis 10⁻⁶ S/cm und einer maximalen Dicke von 100nm, bei dem zumindest einer Dispersion eines Funktionspolymers in einem ersten Lösungsmittel und einer echten Lösung des Funktionspolymers in einem zweiten Lösungsmittel ein drittes Lösungsmitte1 zugegeben wird, anschließend jeweils das erste und das zweite Lösungsmittel abdestilliert wird, wobei eine erste und eine zweite Lösung des Funktionspolymers in dem dritten Lösungsmittel resultiert und Mischen der ersten Lösung des Funktionspolymers in dem dritten Lösungsmittel und der zweiten Lösung des Funktionspolymers in dem dritten Lösungsmitte1, wobei durch das Mischungsverhältnis die Leitfähigkeit der Funktionsschicht eingestellt wird.

2. Verfahren nach Anspruch 1, wobei das erste Lösungsmittel Wasser ist.

3. Verfahren nach einem der vorhergehenden Ansprüche, wobei das zweite Lösungsmittel Ethanol ist.

4. Verfahren nach einem der vorhergehenden Ansprüche, wobei das dritte Lösungsmittel Ethylenglykol ist.

5. Verfahren nach einem der vorhergehenden Ansprüche, wobei das Funktionspolymer PEDOT oder PANI ist.

6. Verfahren nach einem der vorhergehenden Ansprüche, bei dem das Funktionspolymer als Copolymer oder Mischung vorliegt, das PSS umfasst.

7. Verfahren nach einem der vorhergehenden Ansprüche, wobei der Dispersion des Funktionspolymers in dem ersten Lösungsmittel und der echten Lösung des Funktionspolymers in dem zweiten Lösungsmittel jeweils ein gleiches Volumen von dem dritten Lösungsmittel zugegeben wird.

8. Verfahren nach Anspruch 1, wobei
- das erste Lösungsmittel Wasser ist,
- das zweite Lösungsmittel Ethanol ist,
- das dritte Lösungsmittel Ethylenglykol ist,
- das Funktionspolymer PEDOT ist und wobei der Dispersion des PEDOT in Wasser und der echten Lösung des PEDOT in Ethanol jeweils ein gleiches Volumen Ethylenglykol zugegeben wird.

## Claims

1. Process for producing a material for a functional layer having a conductivity in the range from 10⁻⁴ S/cm to 10⁻⁶ S/cm and a maximum thickness of 100 nm, in which a third solvent is added to at least one dispersion of a functional polymer in a first solvent and to a real solution of the functional polymer in a second solvent, then the first and second solvents are each distilled off, resulting in a first solution and a second solution of the functional polymer in the third solvent, and the first solution of the functional polymer in the third solvent and the second solution of the functional polymer in the third solvent are mixed, with adjustment of the conductivity of the functional layer via the mixing ratio.

2. Process according to Claim 1, wherein the first solvent is water.

3. Process according to either of the preceding claims, wherein the second solvent is ethanol.

4. Process according to any of the preceding claims, wherein the third solvent is ethylene glycol.

5. Process according to any of the preceding claims, wherein the functional polymer is PEDOT or PANI.

6. Process according to any of the preceding claims, wherein the functional polymer is present in the form of a copolymer or mixture comprising PSS.

7. Process according to any of the preceding claims, wherein an equal volume of the third solvent is added in each case to the dispersion of the functional polymer in the first solvent and to the real solution of the functional polymer in the second solvent.

8. Process according to Claim 1, wherein
- the first solvent is water,
- the second solvent is ethanol,
- the third solvent is ethylene glycol,
- the functional polymer is PEDOT and wherein an equal volume of ethylene glycol is added in each case to the dispersion of PEDOT in water and to the real solution of PEDOT in ethanol.

## Revendications

1. Procédé de fabrication d'un matériau pour une couche fonctionnelle ayant une conductivité dans la plage allant de 10⁻⁴ S/cm à 10⁻⁶ S/cm et une épaisseur maximale de 100 nm, selon lequel un troisième solvant est ajouté à au moins une dispersion d'un polymère fonctionnel dans un premier solvant et à une solution véritable du polymère fonctionnel dans un deuxième solvant, puis le premier et le deuxième solvant sont chacun éliminés par distillation, une première et une deuxième solution du polymère fonctionnel dans le troisième solvant étant obtenues, et la première solution du polymère fonctionnel dans le troisième solvant et la deuxième solution du polymère fonctionnel dans le troisième solvant étant mélangées, la conductivité de la couche fonctionnelle étant ajustée par le rapport de mélange.

2. Procédé selon la revendication 1, dans lequel le premier solvant est l'eau.

3. Procédé selon l'une quelconque des revendications précédentes, dans lequel le deuxième solvant est l'éthanol.

4. Procédé selon l'une quelconque des revendications précédentes, dans lequel le troisième solvant est l'éthylène glycol.

5. Procédé selon l'une quelconque des revendications précédentes, dans lequel le polymère fonctionnel est PEDOT ou PANI.

6. Procédé selon l'une quelconque des revendications précédentes, dans lequel le polymère fonctionnel se présente sous la forme d'un copolymère ou d'un mélange qui comprend du PSS.

7. Procédé selon l'une quelconque des revendications précédentes, dans lequel un même volume du troisième solvant est ajouté respectivement à la dispersion du polymère fonctionnel dans le premier solvant et à la solution véritable du polymère fonctionnel dans le deuxième solvant.

8. Procédé selon la revendication 1, dans lequel
- le premier solvant est l'eau,
- le deuxième solvant est l'éthanol,
- le troisième solvant est l'éthylène glycol,
- le polymère fonctionnel est le PEDOT, et un même volume d'éthylène glycol est ajouté respectivement à la dispersion du PEDOT dans de l'eau et à la solution véritable du PEDOT dans de l'éthanol.
